# EUROPEAN PATENT SPECIFICATION

(11) **EP 0 391 420 B1**
(45) Date of publication and mention of the grant of the patent: **30.06.1999**
(21) Application number: 90106547.4
(22) Date of filing: 05.04.1990
(51) Int. Cl.: H01L 29/06, H01L 23/556, H01L 21/74

(54) **Radiation resistant semiconductor structure**
Strahlungsresistente Halbleiterstruktur
Structure semi-conductrice résistant à des radiations

(30) Priority: 07.04.1989 JP 8873089
(43) Date of publication of application: 10.10.1990
(73) Proprietor: KABUSHIKI KAISHA TOSHIBA, Kawasaki-shi, Kanagawa-ken 210-8572 (JP); TOSHIBA MICRO-ELECTRONICS CORPORATION, Kawasaki-ku, Kawasaki-shi (JP)
(72) Inventor: Hatano, Hiroshi, c/o Intellectual Property Div., Minato-ku, Tokyo 105 (JP); Yoshii, Ichiro, c/o Intellectual Property Div., Minato-ku, Tokyo 105 (JP); Takatsuka, Satoru, c/o Intellectual Property Div., Minato-ku, Tokyo 105 (JP)
(74) Representative: Lehn, Werner, Dipl.-Ing.

(56) References cited:
- EP-A- 98 165
- EP-A- 0 280 368
- EP-A- 0 282 082
- DE-B- 1 789 026
- US-A- 3 338 758
- US-A- 4 506 436
- PATENT ABSTRACTS OF JAPAN vol. 5, no. 167 (E-79)(839) 24 October 1981 & JP-A-56 094 768 (FUJITSU) 31.07.1981
- IEEE Transactions on Nuclear Science, vol. NS-33, No. 6, December 1986, pages 1505-1509
- IBM TECHNICAL DISCLOSURE BULLETIN vol. 23, no. 2, July 1980, pages 596,597, New York, US; D.B. EARDLEY et al.: "Zero Biased Junction for Reduction of alpha-particle-induced FET-Leakage"

## Description

The present invention relates to a semiconductor device.

A device is described in US-A-3 338 758 comprising: a first P-type region; an element isolating oxide insulation film formed on the first P-type region; and at least two conductive layers disposed close to each other on said element isolating oxide insulation film.

The invention is applicable to a semiconductor device for use in the presence of much radiation, e.g. in space or in a nuclear plant.

Generally, a semiconductor device is provided with a field oxide film for electrically isolating adjacent elements from one another. The field oxide film is very thick.

When the field oxide film is radiated with radiation such as gamma rays, electron-hole pairs are generated in the oxide film. The thicker the oxide film is, the larger the number of electron-hole pairs is. Accordingly, when a semiconductor device is radiated with radiation such as gamma rays, a great number of electron-hole pairs is generated in the thick field oxide film. Various types of potential wirings are layered over the field oxide film. For example, a gate electrode runs across a plurality of element regions of the device. Consider a case where the gate electrode is set at a high potential. Of the electron-hole pairs generated in the field oxide film that underlies the gate electrode, the electrons are attracted by the potential of the gate electrode. Electrons have high mobility in the oxide film. Accordingly, the electrons pass through field oxide film, through the gate electrode. Since the mobility of holes is low in the oxide film, the holes are repulsed by the potential of the gate, and captured and accumulated in the field oxide film, particularly a region in the vicinity of the interface between the field oxide film and the silicon substrate. Therefore, in the case where the semiconductor substrate underlying the field oxide film is a P-type diffusion region, the conductivity type in the surface region of the P-type diffusion region is inverted to the N-type by the accumulated holes. Accordingly, where N-channel MOS transistors are formed in the element regions isolated by the field oxide film, a leak current flows through these transistors via the inverted N-type layer. The leak current possibly causes malfunction of the semiconductor device and increases the power dissipation. From IEEE Transactions on Nuclear Science, Vol NS-33 No. 6, December 1986, pages 1505-1509, later-up free CMOS structures for radiation-tolerant VLSI designs are known. In these structures thin field oxide is combined with a buried p⁺ guard band around each NMOS transistor.

In the semiconductor device of the type in which the adjacent gate electrodes are relatively closely located on the field oxide film, such as a gate array semiconductor device, when such inversion layers are formed under the adjacent gate electrodes, the inversion layers are in contact with each other, and a leak current flows between the gate electrodes.

An object of the present invention is to provide a semiconductor device which is free from the leak current due to radiation, and is operable normally at a location where much radiation exists.

According to the present invention, this object is solved as defined in claim 1. An advantageous embodiment of the invention is defined in claim 2.

This invention can be more fully understood from the following detailed description when taken in conjunction with the accompanying drawings, in which:
Fig. 1A is a plan view showing a semiconductor device according to an embodiment of the present invention;
Fig. 1B is a cross sectional view taken on line IB - IB of Fig. 1A;
Fig. 2A is a plan view showing a semiconductor device not belonging to the present invention; and
Fig. 2B is a cross sectional view taken on line IIB - IIB of Fig. 2A.

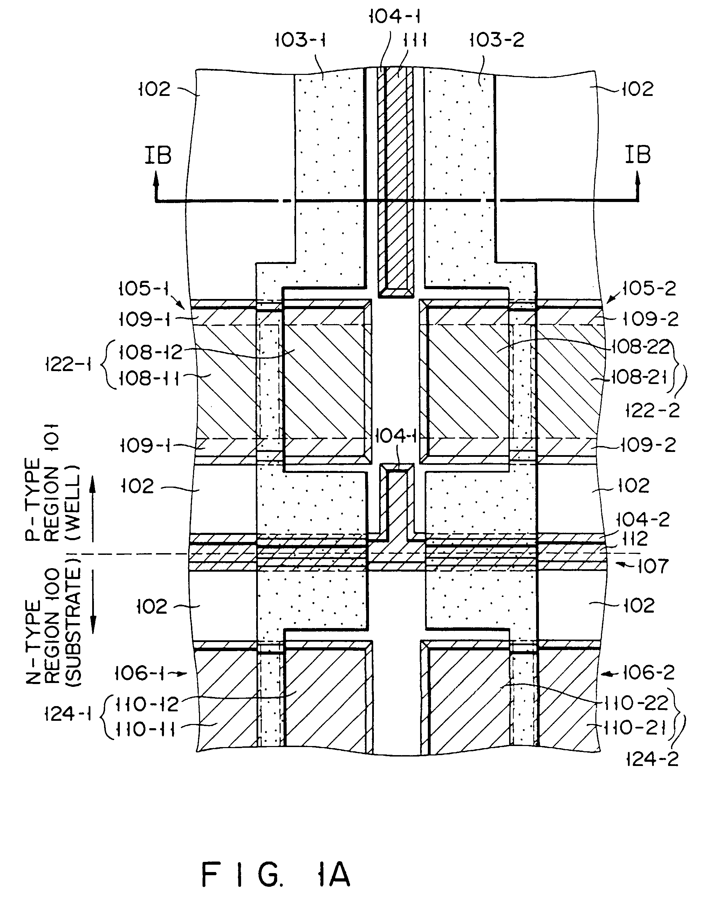

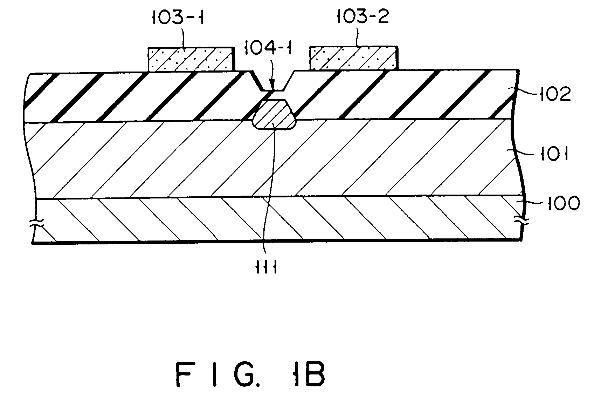

An embodiment of the present invention will be described with reference to Figs. 1A and 1B.

Fig. 1A is a plan view showing a semiconductor device according to an embodiment of the present invention. Fig. 1B is a cross sectional view taken on line IB - IB of Fig. 1A.

The embodiment is a CMOS gate array incorporating the present invention.

As shown in Fig. 1A or 1B, a P-well region 101 is formed in an N-type semiconductor substrate 100. Thick field oxide films 102 as insulating films for element isolation are selectively formed in the surface region of the N-type semiconductor substrate 100. Regions as defined by the field oxide films 102 serve as active element regions. In this instance, four active element regions 105-1, 105-2, 106-1, and 106-2 are exemplarily illustrated, although a number of active element regions are formed in an actual semiconductor device. N-channel MOS transistors 122-1 and 122-2 are formed in the active element regions 105-1 and 105-2 in the P-well region 101. In the transistor 122-1, a region 108-11 serves as a source region, and a region 108-12, as a drain region. In the transistor 122-2, the region 108-21 serves as a source region, and the region 108-22, as a drain region. P-type layers 109-1 for preventing the inversion of the conductivity type, whose impurity concentration is higher than that of the P-well region, are formed on both sides of each N-type region 108-11 and 108-12 as viewed in the direction of the gate length of the transistor 122-1. Similarly, P-type layers 109-2 for preventing the inversion, whose impurity concentration is higher than that of the P-well region, are formed on both sides of each N-type region 108-21 and 108-22 as viewed in the direction of the gate length of the transistor 122-2. An oxide film (not shown), which is thinner than the field oxide film 102, is formed on the P-type layers 109-1 and 109-2, that is, on the end regions of the gates of the N-channel MOS transistors 122-1 and 122-2.

P-channel MOS transistors 124-1 and 124-2 are formed in the active element regions 106-1 and 106-2 in the N-type semiconductor substrate 100. In the transistor 124-1, P-type diffusion regions 110-11 and 110-12 serve as a source region and a drain region. In the transistor 124-2, the P-type diffusion regions 110-21 and 110-22 serve as a source region and a drain region. A gate electrode 103-1 is formed on the active element regions 105-1 and 106-1 and the field oxide film 102. A gate electrode 103-2 is formed on the active element regions 105-2 and 106-2 and the field oxide film 102. These gate electrodes 103-1 and 103-2 are disposed close to each other on the field oxide film 102 within the P-well region 101. A region of the field oxide film 102 which is between the gate electrodes 103-1 and 103-2 is thin. This thin position is denoted by 104-1. Another region of the field oxide film 102 which is on a boundary region 107 between the P-well region 101 and the N-type semiconductor substrate 100 is also thin. This thin portion is denoted by 104-2. A P-type guard band layer 111 whose impurity concentration is higher than that of the P-type inversion prevention layer 109 is formed on a region of the P-well region 101 which is under the thin oxide film 104-1. A P-type guard band layer 112 whose impurity concentration is higher than that of the P-type inversion prevention layer 109 is formed on the regions of the P-well region 101 and the N-type semiconductor substrate 100 which are under the thin oxide film 104-2.

According to the embodiment, in the semiconductor device of the type in which adjacent gate electrodes 103-1 and 103-2 are disposed close to each other on the field oxide film 102, the region 104-1 of the element isolating film 102 located between the adjacent gate electrodes is thinner than the remaining portion. Further, the P-type guard band layer 111 of higher impurity concentration than that of the P-well region 101 is formed under the thin oxide film 104-1. Since the oxide film 104-1 is thin, if it is exposed to radiation such as gamma rays and electron-hole pairs are generated therein, the number of the pairs is small. For this reason, the inversion layer is hard to form in the P-type guard band layer 111. When the instant semiconductor device is exposed to gamma rays, for example, even if the gate electrodes 103-1 and 103-2 are set at high potential, and inversion layers are formed in the regions of the P-well region 101 which are under those electrodes, the formed inversion layers terminate at the guard band layer 111. Therefore, the inversion layers generated under the adjacent gate electrodes do not connect to each other. Accordingly, no leak current flows between the adjacent active elements, ensuring stable and reliable operation of the semiconductor device.

Further, it is noted that in the instance semiconductor device, the thin oxide film 104-2 is formed on the boundary region 107 of the P-well region 101 and the N-type semiconductor substrate 100, and the P-type guard band layer 112 is formed under the thin oxide film 104-2. With this feature, no inversion layer is formed in the boundary region 107. Therefore, a leak current is prevented from generating between the N-type substrate 100, i.e., N-type region, and each of the N-channel MOS FETs 122-1 and 122-2. The fact that the oxide film 104-2 on the guard band layer 112 is thin implies that a less number of electron-hole pairs are formed when this film is subjected to gamma rays. Therefore, this is very effective to prevent the leak current generation, which is due to the radiation. In the present embodiment, the regions of the oxide film (not shown) on the P-type layers 109-1 and 109-2 are thin. Accordingly, the inversion preventing P-type layers 109-1 and 109-2 prevents from occurring a leak current between the source region 108-11 and the drain region 108-12, and a leak current between the source region 108-21 and the drain region 108-22.

To form the thin oxide films 104-1 and 104-2, in a mask forming step preceding to a step for selectively oxidizing the surface region of the substrate to form the field oxide film 102, a nitride film as an acid-proof film used as a mask is patterned such that a portion of the nitride film which is on a region of the substrate where the thin oxide film is to be formed is left. To be more specific, to form the field oxide film 102, a nitride film as an acid-proof film is formed over the substrate, and a photo resist film is formed over the nitride film. The photo resist film is patterned to form a predetermined pattern of a photo resist film. By using the photo resist film as a mask, a field oxide film is formed on the regions of the surface region of the substrate which are not covered by the photo resist film. To form the thin oxide films 104-1 and 104-2, the patterning of the photo resist film is first made such that the nitride film remains on a region of the substrate where the thin oxide film is to be formed, and then when the nitride film is selectively etched, the portion of the nitride film on the region of the substrate where the thin oxide film is to be formed. Accordingly, when the surface region of the substrate is selectively oxidized, no thermal oxide film is formed under the remaining oxide film, and only the thin oxide films 104-1 and 104-2, which are naturally oxidized, exist thereunder.

The P-type guard band layers 111 and 112 can be formed in a high concentration ion implanting step for forming the P-type source regions 110-11 and 110-21 and the P-type drain regions 110-12 and 110-22 of the P-channel MOS transistors 124-1 and 124-2. If these layers are formed in that step, the number of the steps required for manufacturing the semiconductor device will not be increased.

To form the thin oxide films (not shown) at the end regions of the gates of the N-channel MOS transistors which are on the inversion preventing layers 109-1 and 109-2, an oxide film (not shown) formed on the active element regions 105-1 and 105-2, which is later patterned to form the gate oxide films, can be used. Alternatively, another oxide films thinner than the field oxide film 102 can be used.

The thin oxide films 104-1 and 104-2 can be formed by selectively etching the thick field oxide film 102. In this case, the guard band layers 111 and 112 are formed before the formation of the field oxide film 102.

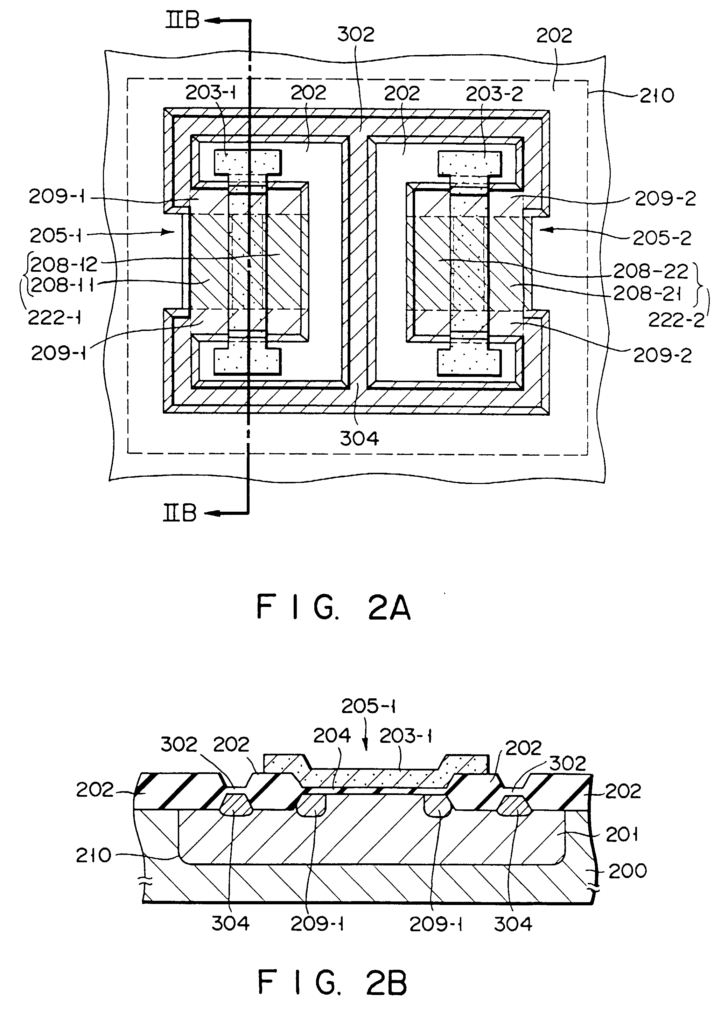

A structure not belonging to the invention will be described with reference to Figs. 2A and 2B.

Fig. 2A is a plan view showing a semiconductor device. Fig. 2B is a cross sectional view taken on line IIB - IIB of Fig. 2A.

As shown in Fig. 2A or 2B, a P-well region 201 is formed in an N-type semiconductor substrate 200. Field oxide films 202 as insulating films for element isolation are selectively formed in the surface region of the N-type semiconductor substrate 200 including the P-well region 201. Regions as defined by the field oxide films 202 serve as active element regions. In this instance, two active element regions 205-1 and 205-2 are exemplarily illustrated, although a number of active element regions are formed in an actual semiconductor device. An N-channel MOS transistor 222-1 having an N-type source region 208-11 and a drain region 208-12, and an N-channel MOS transistor 222-2 having an N-type source region 208-21 and and a drain region 208-22 are formed in the active element regions 205-1 and 205-2 in the P-well region 101, respectively. P-type layers 209-1 for preventing the inversion, whose impurity concentration is higher than that of the P-well region 201, are formed on both sides of each N-type region 208-11 and 208-12 as viewed in the direction of the gate length of the transistor 222-1. Similarly, P-type layers 209-2 for preventing the inversion, whose impurity concentration is higher than that of the P-well region 201, are formed on both sides of each N-type region 208-21 and 208-22 as viewed in the direction of the gate length of the transistor 222-2. As shown in Fig. 2B, those regions of the field oxide film 202 which are on the inversion preventing layers 209-1 and 209-2 are thinned as in the first embodiment. The oxide film at the edge regions of the gates of the N-channel MOS transistors 222-1 and 222-2 is thinned (Fig. 2B), for example, to be approximately equal to the thickness of a thin gate oxide film 204. The gate oxide film 204 is formed over the active element regions 205-1 and 205-2. In the drawing, the gate oxide film on the element region 205-2 is not illustrated. Gate electrode 203-1 and 203-2 of the MOS transistors 222-1 and 222-2 are formed over the active element regions 205-1 and 205-2 and the field oxide film 202. The fringe portion of the gate electrodes which are 203-1 and 203-2, that is, those portions of the gate electrodes which are located off the channels and formed on the field oxide film 202, as viewed from above are substantially surrounded by the thin oxide film 302 and the thin oxide film at the gate end regions of the N-channel MOS transistors. Under the oxide film 302, a P-type guard band layer 304 is formed, whose impurity concentration is higher than that of the inversion preventing P-type layers 209-1 and 209-2. Under the thin oxide films at the gate end regions of the N-channel MOS transistors 222-1 and 222-2, the inversion preventing P-type layers 209-1 and 209-2 are formed. In the figure, reference numeral 210 designates an interface between the substrate 200 and the P-well region 201.

The thin oxide film 302 is formed on the P-type guard band layer 304. Therefore, the conductivity type of the P-type guard band 304 will not be inverted even when the semiconductor device is subjected to radiation and the potential of the gate electrodes 203-1 and 203-2 increase. Accordingly, no current leak occurs between the adjacent active elements. The fringes of the gate electrodes 203-1 and 203-2, as viewed from above, are substantially surrounded by the guard band layer 304 formed under the thin oxide film 302, and the inversion preventing P-type layers 209-1 and 209-2 formed under the thin oxide film at the gate end region. Therefore, if an inversion layer is formed in the region of the P-well region 201 which is under the fringe of the gate electrode 203-1, no leak current will be generated that flows through the inversion layer between the N-type source region 208-11 and the drain region 208-12. Similarly, if an inversion layer is formed in the region of the P-well region 201 which is under the fringe of the gate electrode 203-2, no leak current will be induced that flows through the inversion layer between the N-type source region 208-21 and the drain region 208-22.

The process required to form the thin oxide films may be substantially the same as that used in the embodiment. In a mask forming step preceding to a step for selectively oxidizing the surface region of the substrate 200 to form the field oxide film 202, a nitride film as an acid-proof film used as a mask is patterned such that a portion of the nitride film which is on a region of the substrate where the thin oxide film is to be formed is left. The inversion preventing P-type layers 209-1 and 209-2 and the P-type guard band layer 304 may be formed in a high concentration ion implanting step for forming the P-type source regions and the drain regions of the P-channel MOS transistors (not shown) formed in the N-type substrate 200. If these layers are formed in that step, the number of the steps required to manufacture the semiconductor device will not be increased. To form the thin oxide films at the gate end regions of the N-channel MOS transistors which are on the inversion preventing layers 209-1 and 209-2 (the gate oxide film on the element region 205-2 is not shown), an oxide film (not shown) from on the active element regions 205-1 and 205-2, which is later patterned to form the gate oxide films, may be used. Alternatively, another oxide films thinner than the field oxide film 202 may be used.

As described above, according to the present invention, there is provided a reliable semiconductor device which is free from the leak current due to radiation, and is normally operable in place where much radiation exists.

Reference signs in the claims are intended for better understanding and shall not limit the scope.

## Claims

1. A semiconductor device comprising:
a first P-type region (101, 201) having a first impurity concentration;
an element isolating oxide insulation film (102) which is a field oxide insulation layer formed on the first P-type region, and has a first thickness;
at least two conductive layers (103-1, 103-2) disposed immediatly adjacent to each other on said element isolating oxide insulation film having said first thickness;
a second P-type region (111), being formed in a region of said first P-type region between and extending along the length of said two conductive layers, and having a second impurity concentration higher than the first impurity concentration;
said insulating film having a second thickness in an area (104-1) on the second P-type region, the second thickness being smaller than the first thickness.

2. The semiconductor device according to claim 1, further including:
N-channel MOS transistors (122-1, 122-2), in the first P-type region, including
sources (108-11, 108-21),
channels juxtaposed to the source, and
drains (108-12, 108-22) juxtaposed to the channels;
said element insulating oxide film being thinned over entire regions where the transistors are formed; and
third P-type regions (109-1, 109-2) on the first P-type region, arranged on sides of the channel and each having a side adjacent to and touching the channel and extending from the source to the drain, the third P-type regions having a third impurity concentration higher than the first impurity concentration and lower than the second impurity concentration,
said insulating film having a third thickness in an area on the third P-type region, the third thickness being smaller than the first thickness;
an N-type semiconductor substrate (100) including a P-channel MOS transistor (124-1, 124-2), arranged with the N-channel MOS transistor (122-1, 122-2) in a complementary MOS configuration;
the first P-type region (101) being a P-well region in the N-type semiconductor substrate;
a fourth P-type diffusion region (112), in an interface region between the N-type substrate and the P-well region, the fourth P-type diffusion region having an impurity concentration higher than the first and third impurity concentrations; and
an insulating film having a fourth thickness in an area (104-2) on the fourth P-type region, the fourth thickness being smaller than the first thickness.

## Patentansprüche

1. Ein Halbleiterbauelement, umfassend:
einen ersten P-Typ Bereich (101, 201), der eine erste Verunreinigungskonzentration aufweist;
einen elementisolierenden Oxidisolationsfilm (102), welcher eine Feldoxidisolationsschicht ist, die auf dem ersten P-Typ Bereich ausgebildet ist, und eine erste Dicke aufweist;
mindestens zwei leitende Schichten (103-1, 103-2), die unmittelbar benachbart zueinander auf dem elementisolierenden Oxidisolationsfilm, der die erste Dicke aufweist, angeordnet sind;
einen zweiten P-Typ Bereich (111), der in einem Bereich des ersten P-Typ Bereiches zwischen und sich entlang der Längsrichtung der zwei leitenden Schichten erstreckend ausgebildet ist, und eine zweite Verunreinigungskonzentration aufweist, die größer als die erste Verunreinigungskonzentration ist;
wobei der isolierende Film eine zweite Dicke in einem Gebiet (104-1) auf dem zweiten P-Typ Bereich aufweist, und die zweite Dicke kleiner als die erste Dicke ist.

2. Das Halbleiterbauelement nach Anspruch 1 umfaßt ferner:
N-Kanal MOS-Transistoren (122-1, 122-2) in dem erste P-Typ Bereich, umfassend
Sources (108-11, 108-21),
Kanäle, die neben der Source liegen, und
Drains (108-12, 108-22), die neben den Kanälen liegen;
wobei der elementisolierende Oxidfilm über die gesamten Bereichen wo die Transistoren ausgebildet sind ausgedünnt ist; und
dritte P-Typ Bereiche (109-1, 109-2) auf dem ersten P-Typ Bereich, angeordnet auf beiden Seiten des Kanals, und jeder weist eine Seite benachbart zu und den Kanal berührend auf und erstreckt sich von der Source zum Drain, wobei die dritten P-Typ Bereiche eine dritte Verunreinigungskonzentration aufweisen, die größer als die erste Verunreinigungskonzentration und kleiner als die zweite Verunreinigungskonzentration ist; wobei der isolierende Film eine dritte Dicke in einem Gebiet auf dem dritten P-Typ Bereich aufweist, und die dritte Dicke kleiner als die erste ist;
ein N-Typ Halbleitersubstrat (100), das einen P-Kanal MOS-Transistor (124-1, 124-2)umfaßt, angeordnet mit dem N-Kanal MOS-Transistor (122-1, 122-2) in einer ergänzenden MOS-Konfiguration;
der erste P-Typ Bereich (101) ist ein P-Wannenbereich in dem N-Typ Halbleitersubstrat;
einen vierten P-Typ Diffusionsbereich (112) in einem Schnittstellenbereich zwischen dem N-Typ Substrat und dem P-Wannenbereich, wobei der vierte P-Typ Diffusionsbereich eine Verunreinigungskonzentration aufweist, die größer als die ersten und dritten Verunreinigungskonzentrationen ist; und
einen isolierenden Film, der eine vierte Dicke in einem Gebiet (104-2) auf dem vierten P-Typ Bereich aufweist, wobei die vierte Dicke kleiner ist als die erste Dicke.

## Revendications

1. Dispositif à semiconducteurs comprenant :
une première région de type P (101, 201) présentant une première concentration en impuretés,
un film d'isolement d'oxyde d'isolation d'éléments (102) qui est une couche d'isolement d'oxyde de champ formée sur la première région de type P, et présente une première épaisseur,
au moins deux couches conductrices (103-1, 103-2) disposées immédiatement à proximité l'une de l'autre sur ledit film d'isolement d'oxyde d'isolation d'éléments présentant ladite première épaisseur,
une seconde région de type P (111), qui est formée dans une région de ladite première région de type P entre lesdites deux couches conductrices et s'étendant le long de la longueur de celles-ci, et présentant une seconde concentration en impuretés plus élevée que la première concentration en impuretés,
ledit film d'isolement présentant une seconde épaisseur dans une zone (104-1) sur la seconde région de type P, la seconde épaisseur étant plus petite que la première épaisseur.

2. Dispositif à semiconducteurs selon la revendication 1, comprenant en outre : des transistors de type MOS (métal-oxyde-semi-conducteur) à canal N (122-1, 122-2) dans la première région de type P, comprenant
des sources (108-11, 108-21)
des canaux juxtaposés à la source, et
des drains (108-12, 108-22) juxtaposés aux canaux,
ledit film d'oxyde d'isolation d'éléments étant aminci sur des régions entières où sont formés les transistors, et
des troisièmes régions de type P (109-1, 109-2) sur la première région de type P, disposées des deux côtés du canal et présentant chacune un côté adjacent au canal et rencontrant celui-ci, et s'étendant depuis la source vers le drain, les troisièmes régions de type P présentant une troisième concentration en impuretés plus élevée que la première concentration en impuretés et inférieure à la seconde concentration en impuretés,
ledit film d'isolement présentant une troisième épaisseur dans une zone sur la troisième région de type P, la troisième épaisseur étant plus petite que la première épaisseur,
un substrat de semiconducteur de type N (100) comprenant un transistor de type MOS à canal P (124-1, 124-2), disposé avec le transistor de type MOS à canal N (122-1, 122-2), suivant une configuration de type MOS complémentaire,
la première région de type P (101) étant une région depuis le type P dans le substrat de semiconducteur de type N,
une quatrième région de diffusion de type P (112), dans une région d'interface entre le substrat de type N et la région de puits de type P, la quatrième région de diffusion de type P présentant une concentration en impuretés plus élevée que la première et la troisième concentrations en impuretés, et
un film d'isolement présentant une quatrième épaisseur dans une zone (104-2) sur la quatrième région de type P, la quatrième épaisseur étant plus petite que la première épaisseur.
